# EUROPEAN PATENT SPECIFICATION

(11) **EP 0 441 510 B1**
(45) Date of publication and mention of the grant of the patent: **20.09.1995**
(21) Application number: 91300610.2
(22) Date of filing: 28.01.1991
(51) Int. Cl.: G11C 16/06

(54) **Method for programming programmable elements in programmable devices**
Programmierverfahren für programmierbare Elemente in programmierbaren Anordnungen
Méthode de programmation d'éléments programmables dans des dispositifs programmables

(30) Priority: 08.02.1990 US 476715
(43) Date of publication of application: 14.08.1991
(73) Proprietor: ALTERA CORPORATION, San Jose, California 95134-2020 (US)
(72) Inventor: Norman, Kevin A., Belmont, California 94002 (US); Sansbury, James D., Portola Valley, California 94028 (US); Herrmann, Alan L., Sunnyvale, California 94087 (US); Hendricks, Matthew C., Los Gatos, California 95032 (US); Nouban, Behzad, Mountain View, California 94039 (US)
(74) Representative: Adkins, Michael

(56) References cited:
- US-A- 4 357 685
- US-A- 4 357 685
- ELECTRONICS & WIRELESS WORLD. vol. 95, no. 1636, February 1989, SUTTON GB pages 157 - 160; CROMIE: 'EPLD PROGRAMMER DESIGN'

## Description

### Background of the Invention

Programmable logic devices of the types described generally in Spencer U.S. Patent 3,566,153, Birkner et al. U.S. Patent 4,124,899, Hartmann et al. U.S. Patent 4,609,986, Hartmann et al. U.S. Patent 4,617,479 and Hartmann et al. U.S. Patent 4,713,792 can be implemented using fuses, anti-fuses, erasable programmable read-only memory (EPROM), electrically erasable programmable read-only memory (EEPROM) or flash EPROM as their programmable elements. Such devices are typically set up as basically orthogonal arrays of "bit lines" and "word lines" which can be programmably interconnected to achieve a desired logical result. It is known that the programmable interconnections in such devices can be programmed by addressing the appropriate bit lines and word lines, and transferring the desired programming data to the interconnections by applying to the selected word lines and bit lines a predetermined programming voltage -- e.g., a voltage significantly higher than that encountered in the normal logical operation of the device. When the programmable elements are any of the above-mentioned types of EPROM using floating gate field effect transistors, the high programming voltages trap electrons on the floating gate of the transistor, raising the threshold voltage, as seen from the control gate of the transistor, needed to turn the transistor on. It is desirable that the threshold be raised as high as possible above normal operating voltage, to provide a guard band effect in case of voltage variations during normal operation.

Traditionally, programmable logic devices have been programmed by passing once through the array and sequentially programming each programmable interconnection, or "cell." In the earliest known programming scheme, the programming voltages were applied once to each cell for relatively long periods -- e.g., 45-50 msec. In a later programming scheme, shorter pulses were used -- e.g., 1 msec, and each cell received a plurality -- e.g., up to fifteen -- pulses. In this later scheme, the cell was verified after each pulse, and if that cell had already reached the desired voltage, programming of that cell was discontinued and the process continued on the next cell.

Electronics & Wireless World, Vol 95, No. 1636, February 1989, discloses the design and use of EPROM programmes, including the application of brief 100us programming pulses to the EPROM cell.

US 4357685 discloses the use of pulses which are sufficiently short that the conduction threshold of the EPROM cell is raised to a value less than the minimum level representing its charged state.

In using the prior schemes, it has been observed that certain devices could not be programmed because one or more cells would not reach the desired voltage. This was true even if very long pulses, or a high number -- even higher than the normal number of repetitions -- of pulses, were applied. Other devices could be programmed if very long pulses or a high number of pulses were applied. However, such devices would fail the normal programming procedure and require special handling. In addition, the more one tried to program the difficult cells in such devices, the more one stressed the entire device and disturbed "half-selected" bits -- i.e., other cells which shared either the bit line or the word line of the cell being programmed.

It would be desirable to be able provide a method of programming programmable logic devices that is faster than known programming methods, that achieves the highest possible programmed voltage, and that would decrease the number of failed devices.

It would also be desirable to be able to provide such a programming method that would minimize the stress on the device and the disturbance of already programmed cells.

### Summary of the Invention

It is an object of this invention to provide a method of programming programmable logic devices that is faster than known programming methods, that achieves a higher programmed voltage, and that decreases the number of failed devices.

It is also an object of this invention to provide such a programming method that minimizes the stress on the device and the disturbance of already programmed cells.

According to the invention there is provided a method for programming a programmable logic device, said device having an array of erasable programmable read-only memory (EPROM) cells, each of which has threshold voltage, and to each of which at least one high-voltage programming pulse must ordinarily be applied for a predetermined duration to program said programmable logic device, said method comprising the steps of: selecting a first duration shorter than said predetermined duration; and applying a first number of high-voltage programming pulses to each of said EPROM cells, each of said high-voltage programming pulses having a first magnitude and having said first duration, said number being at least one; characterised in that the method further includes the steps of: selecting a second duration shorter than said first duration; and applying a second number of high-voltage programming pulses to each of said EPROM cells, each of said high-voltage programming pulses having a second magnitude at least as high as said first magnitude and having said second duration, said second number being at least one.

### Brief Description of the Drawings

The above and other objects and advantages of the invention will be apparent upon consideration of the following detailed description, taken in conjunction with the accompanying drawings, in which like reference characters refer to like parts throughout, and in which:
FIG. 1 is a schematic representation of an EPROM transistor used as a programmable interconnection element in programmable logic devices implemented with EPROM;
FIG. 2 is a cross-sectional view of the EPROM transistor of FIG. 1; and
FIGS. 3A and 3B are a diagram of the method of the invention for programming programmable logic devices.

### Detailed Description of the Invention

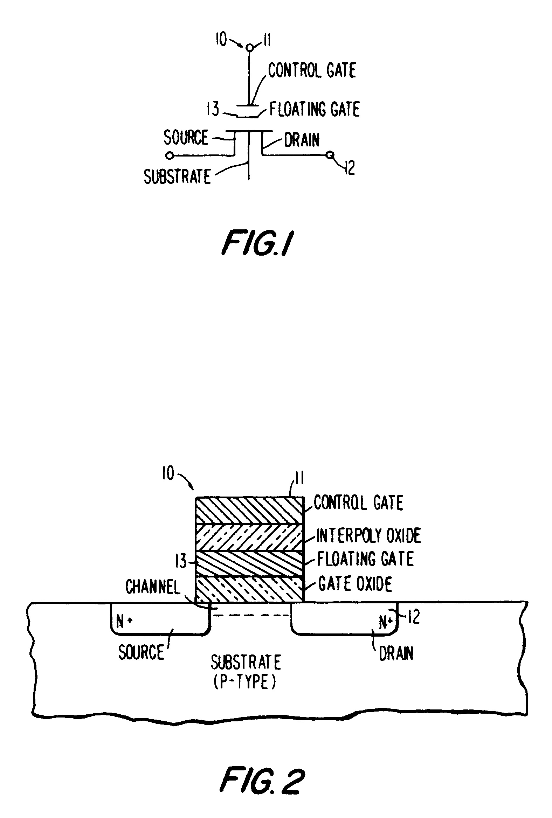

In the case of a programmable logic device using EPROM for its programmable elements, an EPROM element such as a floating gate field effect transistor 10, shown in FIGS. 1 and 2, commonly referred to as an EPROM transistor, is programmed when the voltage on its control gate 11 is at a voltage (e.g., 12 volts) that is significantly higher than the voltage during normal operation (typically 5 volts) and the voltage at the drain 12 of EPROM element 10 is at a voltage (e.g., 10-12 volts) higher than the voltage during normal operation (e.g., 5 volts).

The presence of high voltages at both gate 11 and drain 12 of EPROM transistor 10 causes electrons to be injected into the floating gate 13. Electrons on floating gate 13 remain trapped on floating gate 13 after high voltages are removed. The presence of electrons on floating gate 13 causes the threshold voltage as seen from control gate 11 to be substantially increased from its initial value (e.g., from an initial value of 1 to 2 volts to a new value above 5 volts) such that under normal gate voltages of +5 volts the transistor is not turned on. Thus an unprogrammed EPROM transistor will conduct with 5 volts on the gate and will not conduct with 0 volt on the gate, while a programmed EPROM transistor will not conduct in either state.

The pattern of programmed and unprogrammed cells in a programmable logic array determines the programming of the array. A particular cell (EPROM) is programmed by applying the programming voltages to the bit line and word line at whose intersection the cell lies, the control gate 11 being connected, in the preferred embodiment, to a word line, and the drain 12 being connected, in the preferred embodiment, to a bit line.

As stated above, it is known to program programmable logic devices by applying, to each cell in the array in order, either one pulse of approximately 50 msec duration, or a plurality of pulses of approximately 1 msec duration. However, depending on the individual physical structure of a particular EPROM with the device, it may be harder to program than the average EPROM in the given device, because of minor and expected manufacturing variations in the details of the individual physical structure. Therefore, using the known techniques, there were certain cells that were much more difficult to program, and others that would fail to program to required levels for any chosen number or width of pulses. Further, it is also known that the programmability of an EPROM degrades with temperature. Because the programming process heats the device, the harder one tries to program a difficult cell, the more it may resist being programmed. Moreover, in an array, repeated attempts to program a difficult cell can disturb already programmed cells to the point that they are no longer as fully programmed. Therefore, the degree to which one can continue to attempt to program a difficult cell is limited. On the other hand, if even one cell cannot be adequately programmed, then the entire device may be useless.

The programming method of the present invention allows easier programming of difficult cells in a programmable logic device, while minimizing disturbance of other cells in the device. According to the present invention, a programmable logic device is programmed by passing through the device a plurality of times, preferably three times, applying a plurality of voltage pulses to each cell on each pass. The length of each pulse preferably decreases from pass to pass while the magnitude of each pulse preferably increases.
Preferably, after each pulse the cell being programmed is verified and, if it has already reached the desired programmed voltage, programming of that cell is discontinued. The shortening of the pulse duration and the discontinuing of programming on reaching the programmed voltage both shorten total programming time and minimize stress on the device and disturbances of already programmed and half-selected cells.

In a preferred embodiment of the invention, on the first pass through the programmable array, a maximum of twenty pulses is applied to each cell, each pulse having a duration of 200 µsec. In the second pass, a maximum of eighty pulses each having a duration of 50 µsec are applied to each cell. In the third pass, a maximum of one hundred pulses each having a duration of 20 µsec are applied to each cell. After each pass, the cell is verified -- i.e., tested to see if it has reached the desired programmed voltage -- and if it has reached the programmed voltage, the number of pulses applied to that cell during that pass may be applied again, each for the same duration, to raise the threshold voltage of the cell that much higher over the desired threshold. This "overpulse" technique has the effect of raising the programmed threshold voltage so high that no further programming of most bits will be required. Programming of that cell is then discontinued for that pass. In addition, if a particular cell cannot be verified after the maximum number of pulses of a particular pass, that maximum number of pulses is applied again to that cell, each with the same duration, in case that may prove effective to program the cell, because the alternative is to discard the entire device. This can be done safely because in the event the last regular pulse had been successful, the maximum number of pulses would have been applied again anyway as overpulses.

The amplitude of the programming pulses depends on the physics of the particular device being programmed, while the duration and number of pulses depend on the application and the particular target programmed voltage. In a preferred embodiment of the invention, a programming pulse is applied by applying a voltage between about 12 volts and about 20 volts to the gate of the EPROM cell and a voltage between about 6 volts and about 12 volts to the drain of the EPROM cell. The cell is tested, or verified, by changing the gate voltage to the test voltage and observing the drain-to-source conduction. If the current conducted is more than 1 microamp, the cell is not programmed high enough. If the current conducted is less than 1 microamp, then the cell is programmed to at least the test voltage. In the preferred embodiment, the test voltages for each cell during the first, second and third passes, respectively, are 6.0 volts, 7.6 volts, and 8.2 volts and all cells are verified to 7.6 volts at the end of the first pass, and to 8.2 volts at the end of the second and third passes.

The method of the present invention has been observed to allow the programming of difficult cells more easily, and even to allow the programming of cells that could not be programmed at all using previously known programming methods. Although it is not certain, and is not intended as a limitation of the present invention, it is believed that by using shorter pulses, the present method puts less stress on the device being programmed, and also generates less heat, which otherwise would increase the difficulty of programming.

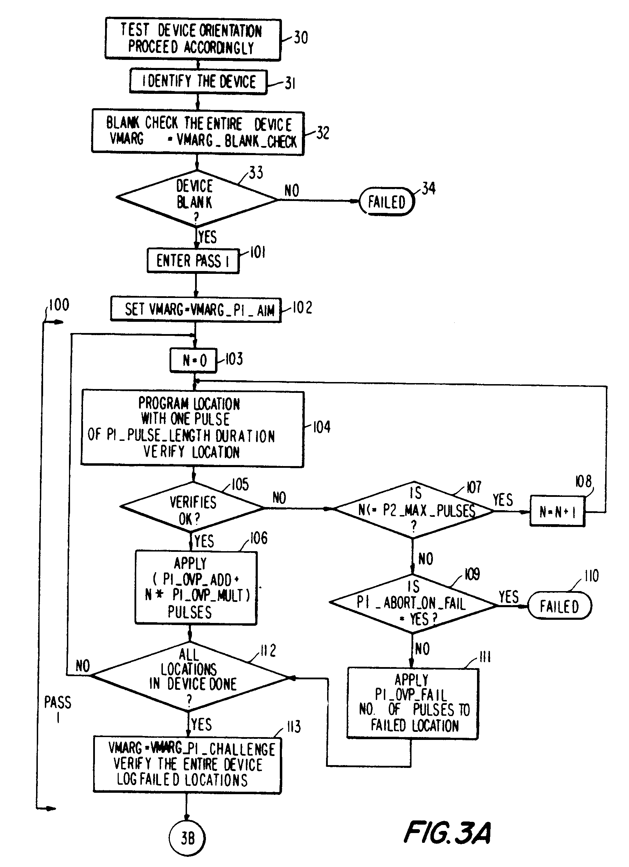

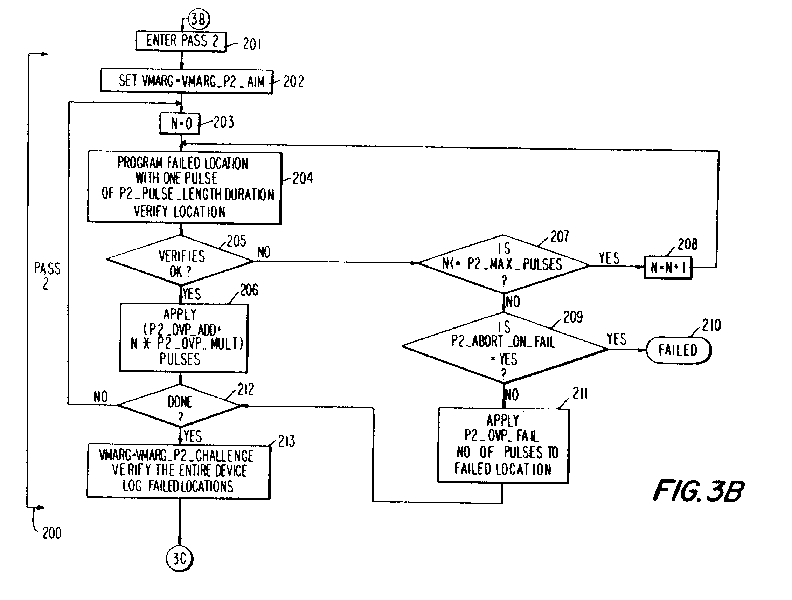

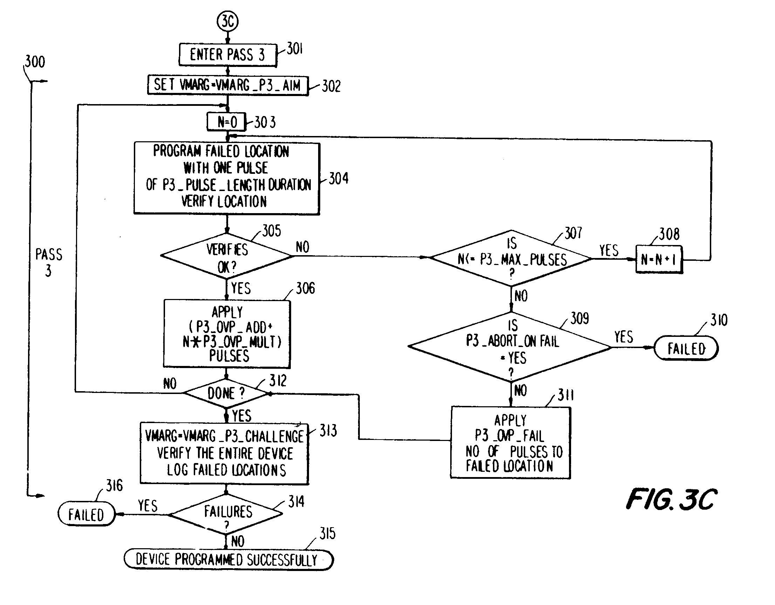

The method of the present invention is diagrammed in FIGS. 3A and 3B. Steps 30-34 are preliminary steps. The method begins at step 30, and the device to be programmed is identified at step 31, allowing the choice of the appropriate parameters. At step 32, in preparation for verifying that the device is in fact blank, and therefore ready for programming, a voltage value VMARG is set to VMARG_BLANK_CHECK, which is a minimum voltage level which, if present on any cell in the device, indicates that the device is not blank. In a preferred embodiment, VMARG_BLANK_CHECK = 3.7 volts. At step 33, each cell is tested to see if the device is blank. If at step 33 the device is not blank, then the device fails the programming process, which then ends at 34. If at step 33 the device is blank, then the process continues with the first programming pass 100, which begins at 101.

At step 102, in preparation for first programming pass 100, VMARG is set to VMARG_P1_AIM, the target voltage for the first programming pass. In a preferred embodiment, VMARG_P1_AIM = 6.0 volts. At step 103, a counter N, which represents the number of programming pulses applied, is set to zero. At step 104, a cell is programmed with one programming pulse.

If at step 105 the cell can be verified at VMARG_P1_AIM, meaning that the (N+1)th pulse raised the cell to the desired programmed voltage, then at step 106 a number of additional pulses, or "overpulses" is applied to the cell to further raise the cell voltage to protect it against disturbances that might otherwise cause the cell to become unprogrammed. The number of overpulses is equal to P1_OVP_ADD + N x P1_OVP_MULT, where P1_OVP_ADD and P1_OVP_MULT are predetermined overpulse constants. In a preferred embodiment, P1_OVP_ADD = 0 and P1_OVP_MULT = 1, so that the number of overpulses equals the number of pulses that were necessary to originally program the cell.

If at step 105 the cell cannot be verified, meaning the (N+1)th pulse has not raised the cell to the desired programmed voltage, then at step 107 N is tested to see if it is less than P1_MAX_PULSES, which represents a predetermined maximum number of pulses to be applied to any one cell during the first programming pass. In a preferred embodiment, P1_MAX_PULSES = 20. If N is less than or equal to P1_MAX_PULSES, then at step 108, N is incremented by 1 and the process returns to step 104. If at step 107 N is greater than P1_MAX_PULSES, then at step 109, the value of P1_ABORT_ON_FAIL, which determines whether or not additional attempts to program the device should be made, is examined. In a preferred embodiment, P1_ABORT_ON_FAIL = NO, meaning that further attempts should be made, and at step 111, P1_OVP_FAIL overpulses are applied to the cell, just in case they prove sufficient to program the cell. This can be done because one is prepared to apply a certain number of overpulses to the cell at step 106 even if programming were successful. In a preferred embodiment, P1_OVP_FAIL = 0. If P1_ABORT_ON_FAIL = YES, then at step 110 the device is considered to have failed the programming process, which ends there.

At step 112, after the application of overpulses (if any) at step 106 or 111, there is a test to determine if all cells have been addressed yet in the first programming pass. If all cells have not yet been addressed, the process returns to step 103, now pointing to the next address to be programmed. If all cells have been addressed, then at step 113 then entire device is verified by testing each cell against a test voltage VMARG = VMARG_P1_CHALLENGE, which, in a preferred embodiment, is 7.6 volts. Those cells which fail this verification are logged for further programming in second programming pass 200, which begins at step 201.

At step 202, in preparation for second programming pass 200, VMARG is set to VMARG_P2_AIM, the target voltage for the second programming pass. In a preferred embodiment, VMARG_P2_AIM = 7.6 volts. At step 203, a counter N, which represents the number of programming pulses applied, is set to zero. At step 204, a cell that had been logged in step 113 is programmed with one programming pulse.

If at step 205 the cell can be verified at VMARG_P2_AIM, meaning that the (N+1)th pulse raised the cell to the desired programmed voltage, then at step 206 a number of overpulses is applied to the cell to further raise the cell voltage to protect it against disturbances that might otherwise cause the cell to become unprogrammed. The number of overpulses is equal to P2_OVP_ADD + N x P2_OVP_MULT, where P2_OVP_ADD and P2_OVP_MULT are predetermined overpulse constants. In a preferred embodiment, P2_OVP_ADD = 0 and P2_OVP_MULT = 0, so that no overpulses are applied to the cell.

If at step 205 the cell cannot be verified, meaning the (N+1)th pulse has not raised the cell to the desired programmed voltage, then at step 207 N is tested to see if it is less than P2_MAX_PULSES, which represents a predetermined maximum number of pulses to be applied to any one cell during the second programming pass. In a preferred embodiment, P2_MAX_PULSES = 80. If N is less than or equal to P2_MAX_PULSES, then at step 208, N is incremented by 1 and the process returns to step 204. If at step 207 N is greater than P2_MAX_PULSES, then at step 209, the value of P2_ABORT_ON_FAIL, which determines whether or not additional attempts to program the device should be made, is examined. If P2_ABORT_ON_FAIL = YES, meaning no further attempts should be made, then at step 210 the device is considered to have failed the programming process, which ends there. If, as in a preferred embodiment, P2_ABORT_ON_FAIL = NO, then at step 211, P2_OVP_FAIL overpulses are applied to the cell, just in case they prove sufficient to program the cell. This can be done because one may be prepared to apply a certain number of overpulses to the cell at step 206 even if programming were successful. In a preferred embodiment, P2_OVP_FAIL = 80, consistent with P2_MAX_PULSES = 80.

At step 212, after the application of overpulses (if any) at step 206 or 211, there is a test to determine if all cells logged in step 113 have been addressed yet in the second programming pass. If all cells have not yet been addressed, the process returns to step 203, now pointing to the next address to be programmed. If all cells have been addressed, then at step 213 then entire device is verified by testing each cell against a test voltage VMARG = VMARG_P2_CHALLENGE, which, in a preferred embodiment, is 8.2 volts. Those cells which fail this verification are logged for further programming in third programming pass 300, which begins at step 301.

At step 302, in preparation for third programming pass 300, VMARG is set to VMARG_P3_AIM, the target voltage for the third programming pass. In a preferred embodiment, VMARG_P3_AIM = 8.2 volts. At step 303, a counter N, which represents the number of programming pulses applied, is set to zero. At step 304, a cell that had been logged in step 213 is programmed with one programming pulse.

If at step 305 the cell can be verified at VMARG_P3_AIM, meaning that the (N+1)th pulse raised the cell to the desired programmed voltage, then at step 306 a number of overpulses is applied to the cell to further raise the cell voltage to protect it against disturbances that might otherwise cause the cell to become unprogrammed. The number of overpulses is equal to P3_OVP_ADD + N x P3_OVP_MULT, where P3_OVP_ADD and P3_OVP_MULT are predetermined overpulse constants. In a preferred embodiment, P3_OVP_ADD = 0 and P3_OVP_MULT = 0, so that no overpulses are applied to the cell.

If at step 305 the cell cannot be verified, meaning the (N+1)th pulse has not raised the cell to the desired programmed voltage, then at step 307 N is tested to see if it is less than P3_MAX_PULSES, which represents a predetermined maximum number of pulses to be applied to any one cell during the third programming pass. In a preferred embodiment, P3_MAX_PULSES = 100. If N is less than or equal to P3_MAX_PULSES, then at step 308, N is incremented by 1 and the process returns to step 304. If at step 307 N is greater than P3_MAX_PULSES, then at step 309, the value of P3_ABORT_ON_FAIL, which determines whether or not additional attempts to program the device should be made, is examined. If P3_ABORT_ON_FAIL = YES, meaning no further attempts should be made, then at step 310 the device is considered to have failed the programming process, which ends there. If, as in a preferred embodiment, P3_ABORT_ON_FAIL = NO, then at step 311, P3_OVP_FAIL overpulses are applied to the cell, just in case they prove sufficient to program the cell. This can be done because one may be prepared to apply a certain number of overpulses to the cell at step 306 even if programming were successful. In a preferred embodiment, P3_OVP_FAIL = 100, consistent with P3_MAX_PULSES = 100.

At step 312, after the application of overpulses (if any) at step 306 or 311, there is a test to determine if all cells logged in step 213 have been addressed yet in the third programming pass. If all cells have not yet been addressed, the process returns to step 303, now pointing to the next address to be programmed. If all cells have been addressed, then at step 313 then entire device is verified by testing each cell against a test voltage VMARG = VMARG_P3_CHALLENGE, which, in a preferred embodiment, is 8.2 volts. Those cells which fail this verification are logged. At step 314, the log is examined for failures. If no failures are found, then at step 315 the device is considered to have been programmed successfully. If failures are found in step 314, then at step 316 the device is considered to have failed the programming process. Alternatively, at step 316 the device may enter a remedial programming process of a previously known type.

Thus it is seen that the present invention provides a method of programming programmable logic devices that is faster than known programming methods, that achieves a higher programmed voltage, and that decreases the number of failed devices. This invention also provides such a programming method that minimizes the stress on the device and the disturbance of already programmed cells. One skilled in the art will appreciate that the present invention can be practiced by other than the described embodiments, which are presented for purposes of illustration and not of limitation, and the present invention is limited only by the claims which follow.

## Claims

1. A method for programming a programmable logic device, said device having an array of erasable programmable read-only memory (EPROM) cells (10), each of which has threshold voltage, and to each of which at least one high-voltage programming pulse must ordinarily be applied for a predetermined duration to program said programmable logic device, said method comprising the steps of: selecting a first duration shorter than said predetermined duration; and applying (104) a first number of high-voltage programming pulses to each of said EPROM cells (10), each of said high-voltage programming pulses having a first magnitude and having said first duration, said number being at least one: characterised in that the method further includes the steps of: selecting a second duration shorter than said first duration; and applying (204) a second number of high-voltage programming pulses to each of said EPROM cells (10), each of said high-voltage programming pulses having a second magnitude at least as high as said first magnitude and having said second duration, said second number being at least one.

2. The programming method of Claim 1 further characterised by: after each one of said first number of high-voltage programming pulses of said first magnitude and said first duration has been applied to one of said EPROM cells (10), measuring (105) the threshold voltage of said one of said EPROM cells (10); and if said threshold voltage as measured at least equals a first predetermined voltage, discontinuing (315) the programming of said one of said EPROM cells (10).

3. The programming method of Claim 2 characterised by: counting (103,108) in a first counting step the first number of said high-voltage programming pulses of said first magnitude and said first duration applied to said one of said EPROM cells (10); and if said threshold voltage as measured at least equals a first predetermined voltage, then prior to discontinuing (315) the programming of said one of said EPROM cells (10), applying again (106) to said one of said EPROM cells the first number of high voltage programming pulses counted in said first counting step.

4. The programming method of Claim 3 characterised in that there is a first predetermined maximum number of said high-voltage programming pulses of said first duration to be applied to each of said EPROM cells.

5. The programming method of Claim 4 characterised in that if (107), after said first predetermined maximum number of high voltage programming pulses of said first magnitude and said first duration have been applied, said threshold voltage as measured is less than said first predetermined voltage, the method includes the further steps of: applying again (111) to said one of said EPROM cells (10) said first predetermined maximum number of high-voltage programming pulses of said first magnitude and said first duration, measuring again (113) said threshold voltage of said one of said EPROM cells (10), and, if said threshold voltage as measured is at least equal to said first predetermined voltage, discontinuing (315) the programming of said one of said EPROM cells (10).

6. The programming method of any preceding claim further characterised by: after each one of second number of high-voltage programming pulses of said second magnitude and said second duration has been applied to one of said EPROM cells (10), measuring (205) the threshold voltage of said one of said EPROM cells (10); and if said threshold voltage as measured at least equals a second predetermined voltage, discontinuing (315) the programming of said one of said EPROM cells (10).

7. The programming method of Claim 6 characterised in that said second predetermined voltage is at least equal to said first predetermined voltage.

8. The programming method of Claim 7 wherein said second predetermined voltage is higher than said first predetermined voltage.

9. The programming method of one of Claims 6 - 8 further characterised by: counting (203,208) in a second counting step the second number of high-voltage programming pulses of said second magnitude and said second duration applied to one of said EPROM cells; and if said threshold voltage as measured at least equals a second predetermined voltage, then prior to discontinuing (315) the programming of said one of said EPROM cells (10), applying again (206) to said one of said EPROM cells (10) the second number of high-voltage programming pulses of said second magnitude and said second duration counted in said second counting step.

10. The programming method of Claim 9 characterised in that there is a second predetermined maximum number of high voltage programming pulses of said second magnitude and said second duration to be applied to said one of said erasable programmable read-only memory cells.

11. The programming method of Claim 10 further characterised in that if, (207) after said second predetermined maximum number of high-voltage programming pulses of said second magnitude and said second duration have been applied, said threshold voltage as measured is less than said second predetermined voltage, the method includes the further steps of applying again (211) to said one of said EPROM cells (10) said second predetermined maximum number of high-voltage programming pulses of said second magnitude and said second duration, measuring again said threshold voltage of said one of said EPROM cells (10), and, if said threshold voltage as measured is at least equal to said second predetermined voltage, discontinuing (315) the programming of said one of said EPROM cells (10).

12. The programming method of Claim 10 or 11 characterised in that said second predetermined maximum number is at least equal to said first predetermined maximum number.

13. The programming method of any preceding claim further characterised by: selecting a third duration at most as long as said second duration: and applying (304) a third number of high-voltage EPROM cells (10), each of said high-voltage programming pulses having a third magnitude and said third duration, said third number being at least one.

14. The programming method of Claim 13 further characterised by: after each of said third number of high-voltage programming pulses of said third magnitude and said third duration to one of said EPROM cells (10), measuring (305) the threshold voltage of said one of said EPROM cells (10); and if said threshold voltage as measured at least equals a third predetermined voltage, discontinuing (315) the programming of said one of said EPROM cells (10).

15. The programming method of Claim 14 characterised in that said third predetermined voltage is at least equal to said second predetermined voltage.

16. The programming method of Claim 15 characterised in that said third predetermined voltage is higher than said second predetermined voltage.

17. The programming method of any one of claims 14 - 16 further characterised by counting (303,308) in a third counting step the third number of high-voltage programming pulses of said third magnitude and said third duration applied to one of said EPROM cells; and if said threshold voltage as measured at least equals a third predetermined voltage, then prior to discontinuing (315) the programming of said one of said EPROM cells (10), applying again (306) to said one of said EPROM cells (10), the third number of high-voltage programming pulses of said third magnitude and said third duration counted in said third counting step.

18. The programming method of Claim 17 characterised in that there is a third predetermined maximum number of high-voltage programming pulses of said third magnitude and said third duration to be applied to said one of said EPROM cells (10).

19. The programming method of Claim 18 further characterised in that if, (307) after said third predetermined maximum number of high-voltage programming pulses of said third magnitude and said third duration have been applied, said threshold voltage as measured is less than said third predetermined voltage, the method includes the further steps of: applying again (311) to said one of said EPROM cells (10) said third predetermined maximum number of high-voltage programming pulses of said third magnitude and said third duration, measuring again said threshold voltage of said one of said EPROM cells (10) and, if said threshold voltage as measured is at least equal to said third predetermined voltage, discontinuing (315) the programming of said one of said EPROM cells (10).

20. The programming method of Claim 18 or 19 characterised in that said third predetermined maximum number is at least equal to said second predetermined maximum number.

21. The programming method of Claim 20 characterised in that said third predetermined maximum number is greater than said second predetermined maximum number.

22. The programming method of any one of Claims 13 to 21 characterised in that said third magnitude is at least equal to said second magnitude.

23. The programming method of Claim 22 characterised in that said third magnitude is greater than said second magnitude.

24. The programming method of any one of Claims 13 to 23 characterised in that said third duration is shorter than said second duration.

25. The programming method of any one of Claims 12 to 24 characterised in that said second predetermined maximum number is greater than said first predetermined maximum number.

26. The programming method of any preceding claim characterised in that said second magnitude is greater than said first magnitude.

## Patentansprüche

1. Verfahren zum Programmieren einer programmierbaren Logikvorrichtung, wobei die Vorrichtung eine Reihe elektrisch löschbarer, programmierbarer Festwertspeicher (EPROM) -zellen (10) aufweist, die jeweils eine Schwellenspannung aufweisen und denen jeweils mindestens ein Programmierimpuls einer hohen Spannung für eine vorgegebene Zeitdauer zugeführt werden muß, um die programmierbare Logikvorrichtung zu programmieren, wobei das Verfahren die Schritte aufweist: Auswählen einer ersten Zeitdauer, die kürzer ist als die vorgegebene Zeitdauer; und Zuführen (104) einer ersten Anzahl von Programmierimpulsen einer hohen Spannung zu jeder der EPROM-Zellen (10), wobei jeder der Programmierimpulse der hohen Spannung eine erste Impulshöhe und eine der ersten Zeitdauer entsprechende erste Impulsdauer aufweist, wobei die Anzahl mindestens Eins beträgt; **dadurch gekennzeichnet, daß** das Verfahren ferner die Schritte aufweist: Auswählen einer zweiten Zeitdauer, die kürzer ist als die erste Zeitdauer, und Zuführen (204) einer zweiten Anzahl von Programmierimpulsen einer hohen Spannung zu jeder der EPROM-Zellen (10), wobei jeder der Programmierimpulse eine zweite Impulshöhe, die mindestens so groß ist wie die erste Impulshöhe, und eine der zweiten Zeitdauer entsprechende zweite Impulsdauer aufweist und die zweite Anzahl mindestens Eins beträgt.

2. Programmierverfahren nach Anspruch 1, **dadurch gekennzeichnet, daß**, nachdem jeder der ersten Anzahl von Programmierimpulsen der ersten Impulshöhe und der ersten Impulsdauer einer der EPROM-Zellen (10) zugeführt wurde: Messen (105) der Schwellenspannung der einen EPROM-Zelle (10) und, wenn die gemessene Schwellenspannung einer ersten vorgegebenen Spannung gleich oder größer als diese ist: Unterbrechen (315) der Programmierung der einen EPROM-Zelle (10).

3. Programmierverfahren nach Anspruch 2, **gekennzeichnet durch**: Zählen (103, 108) der der einen EPROM-Zelle (10) zugeführten ersten Anzahl von Programmierimpulsen der ersten Impulshöhe und der ersten Impulsdauer in einem ersten Zählschritt und, wenn die gemessene Schwellenspannung einer ersten vorgegebenen Spannung gleich oder größer als diese ist: erneutes Zuführen (106) der im ersten Zählschritt gezählten ersten Anzahl von Programmierimpulsen zur einen EPROM-Zelle (10), bevor die Programmierung der einen EPROM-Zelle (10) unterbrochen wird.

4. Programmierverfahren nach Anspruch 3, **dadurch gekennzeichnet, daß** jeder der EPROM-Zellen eine erste vorgegebene maximale Anzahl der Programmierimpulse der hohen Spannung und der ersten Impulsdauer zugeführt wird.

5. Programmierverfahren nach Anspruch 4, **dadurch gekennzeichnet, daß**, wenn (107), nachdem die erste vorgegebene maximale Anzahl von Programmierimpulsen der ersten Impulshöhe und der ersten Impulsdauer zugeführt wurde, die gemessene Schwellenspannung niedriger ist als die erste vorgegebene Spannung, das Verfahren ferner die Schritte aufweist: erneutes Zuführen (111) der ersten vorgegebenen maximalen Anzahl von Programmierimpulsen der ersten Impulshöhe und der ersten Impulsdauer zur einen EPROM-Zelle (10), erneutes Messen (113) der Schwellenspannung der EPROM-Zelle (10) und, wenn die gemessene Schwellenspannung der ersten vorgegebenen Spannung gleich oder größer als diese ist: Unterbrechen (315) der Programmierung der einen EPROM-Zelle (10).

6. Programmierverfahren nach einem der vorangehenden Ansprüche, ferner **gekennzeichnet durch**: nachdem jeder der zweiten Anzahl von Programmierimpulsen der zweiten Impulshöhe und der zweiten Impulsdauer einer der EPROM-Zellen (10) zugeführt wurde: Messen (205) der Schwellenspannung der einen EPROM-Zelle (10) und, wenn die gemessene Schwellenspannung der zweiten vorgegebenen Spannung gleich oder größer als diese ist: Unterbrechen (315) der Programmierung der einen EPROM-Zelle (10).

7. Programmierverfahren nach Anspruch 6, **dadurch gekennzeichnet, daß** die zweite vorgegebene Spannung der ersten vorgegebenen Spannung gleich oder größer als diese ist.

8. Programmierverfahren nach Anspruch 7, wobei die zweite vorgegebene Spannung größer ist als die erste vorgegebene Spannung.

9. Programmierverfahren nach einem der Ansprüche 6 bis 8, ferner gekennzeichnet durch: Zählen (203, 208) der der einen der EPROM-Zellen (10) zugeführten zweiten Anzahl von Programmierimpulsen der zweiten Impulshöhe und der zweiten Impulsdauer in einem zweiten Zählschritt und, wenn die gemessene Schwellenspannung einer zweiten vorgegebenen Spannung gleich oder größer als diese ist: erneutes Zuführen (206) der im zweiten Zählschritt gezählten zweiten Anzahl von Programmierimpulsen der zweiten Impulshöhe und der zweiten Impulsdauer zur einen EPROM-Zelle (10), bevor die Programmierung der einen EPROM-Zelle (10) unterbrochen wird (315).

10. Programmierverfahren nach Anspruch 9, **dadurch gekennzeichnet, daß** der einen der EPROM-Zellen eine zweite vorgegebene maximale Anzahl von Programmierimpulsen der zweiten Impulshöhe und der zweiten Impulsdauer zugeführt wird.

11. Programmierverfahren nach Anspruch 10, ferner **dadurch gekennzeichnet, daß**, wenn, nachdem die zweite vorgegebene Anzahl von Programmierimpulsen der zweiten Impulshöhe und der zweiten Impulsdauer zugeführt wurden (207), die gemessene Schwellenspannung kleiner ist als die zweite vorgegebene Spannung, das Verfahren ferner die Schritte aufweist: erneutes Zuführen (211) der zweiten maximalen Anzahl von Programmierimpulsen der zweiten Impulshöhe und der zweiten Impulsdauer zur einen EPROM-Zelle (10), erneutes Messen der Schwellenspannung der einen EPROM-Zelle (10), und, wenn die gemessene Schwellenspannung der zweiten vorgegebenen Spannung gleich oder größer als diese ist: Unterbrechen (315) der Programmierung der einen EPROM-Zelle (10).

12. Programmierverfahren nach Anspruch 10 oder 11, **dadurch gekennzeichnet, daß** die zweite vorgegebene maximale Anzahl der ersten vorgegebenen maximalen Anzahl gleich oder größer als diese ist.

13. Programmierverfahren nach einem der vorangehenden Ansprüche, ferner **gekennzeichnet durch** die Schritte: Auswählen einer dritten Zeitdauer, die der zweiten Zeitdauer gleich oder kürzer als diese ist, und: Zuführen (304) einer dritten Anzahl von Programmierimpulsen einer hohen Spannung zu jeder der EPROM-Zellen (10), wobei jeder der Programmierimpulse eine dritte Impulshöhe und eine der dritten Zeitdauer entsprechende dritte Impulsdauer aufweist und die dritte Anzahl mindestens Eins beträgt.

14. Programmierverfahren nach Anspruch 13, ferner **gekennzeichnet durch** die Schritte: nachdem jeder der dritten Anzahl von Programmierimpulsen der dritten Impulshöhe und der dritten Impulsdauer einer der EPROM-Zellen (10) zugeführt wurde: Messen (305) der Schwellenspannung der einen EPROM-Zelle (10) und, wenn die gemessene Schwellenspannung einer dritten vorgegebenen Spannung gleich oder größer als diese ist: Unterbrechen (315) der Programmierung der einen EPROM-Zelle (10).

15. Programmierverfahren nach Anspruch 14, **dadurch gekennzeichnet, daß** die dritte vorgegebene Spannung der zweiten vorgegebenen Spannung gleich oder größer als diese ist.

16. Programmierverfahren nach Anspruch 15, **dadurch gekennzeichnet, daß** die dritte vorgegebene Spannung größer ist als die zweite vorgegebene Spannung.

17. Programmierverfahren nach einem der Ansprüche 14-16, ferner **gekennzeichnet durch** die Schritte: Zählen (303, 308) der der einen EPROM-Zelle zugeführten dritten Anzahl von Programmierimpulsen der dritten Impulshöhe und der dritten Impulsdauer in einem dritten Zählschritt und, wenn die gemessene Schwellenspannung einer dritten vorgegebenen Spannung gleich oder größer als diese ist: erneutes Zuführen (306) der im dritten Zählschritt gezählten dritten Anzahl von Programmierimpulsen der dritten Impulshöhe und der dritten Impulsdauer zu der einen EPROM-Zelle (10), bevor die Programmierung der einen EPROM-Zelle (10) unterbrochen wird (315).

18. Programmierverfahren nach Anspruch 17, **dadurch gekennzeichnet, daß** der einen EPROM-Zelle (10) eine dritte vorgegebene maximale Anzahl von Programmierimpulsen der dritten Impulshöhe und der dritten Impulsdauer zugeführt wird.

19. Programmierverfahren nach Anspruch 18, ferner **dadurch gekennzeichnet, daß**, wenn, nachdem die dritte maximale Anzahl von Programmierimpulsen der dritten Impulshöhe und der dritten Impulsdauer zugeführt wurden (307), die gemessene Schwellenspannung niedriger ist als die dritte vorgegebene Spannung, das Verfahren die weiteren Schritte aufweist: erneutes Zuführen (311) der dritten maximalen Anzahl von Programmierimpulsen der dritten Impulshöhe und der dritten Impulsdauer zur einen EPROM-Zelle (10), erneutes Messen der Schwellenspannung der einen EPROM-Zelle (10) und, wenn die gemessene Schwellenspannung der dritten vorgegebenen Spannung gleich oder größer als diese ist: Unterbrechen (315) der Programmierung der einen EPROM-Zelle (10).

20. Programmierverfahren nach Anspruch 18 oder 19, **dadurch gekennzeichnet, daß** die dritte vorgegebene maximale Anzahl der zweiten vorgegebenen maximalen Anzahl gleich oder größer als diese ist.

21. Programmierverfahren nach Anspruch 20, **dadurch gekennzeichnet, daß** die dritte vorgegebene maximale Anzahl größer ist als die zweite vorgegebene maximale Anzahl.

22. Programmierverfahren nach einem der Ansprüche 13 bis 21, **dadurch gekennzeichnet, daß** die dritte Impulshöhe der zweiten Impulshöhe gleich oder größer als diese ist.

23. Programmierverfahren nach Anspruch 22, **dadurch gekennzeichnet, daß** die dritte Impulshöhe größer ist als die zweite Impulshöhe.

24. Programmierverfahren nach einem der Ansprüche 13 bis 23, **dadurch gekennzeichnet, daß** die dritte Zeitdauer kürzer ist als die zweite Zeitdauer.

25. Programmierverfahren nach einem der Ansprüche 12 bis 24, **dadurch gekennzeichnet, daß** die zweite vorgegebene maximale Anzahl größer ist als die erste vorgegebene maximale Anzahl.

26. Programmierverfahren nach einem der vorangehenden Ansprüche, **dadurch gekennzeichnet, daß** die zweite Impulshöhe größer ist als die erste Impulshöhe.

## Revendications

1. Procédé de programmation d'un dispositif logique programmable, ledit dispositif étant pourvu d'une matrice de cellules de mémoire morte programmable effaçable (EPROM) (10), chacune d'entre elles disposant d'un seuil de tension, et sur chacune d'entre elles, au moins une impulsion de programmation à haute tension doit normalement être appliquée pendant une durée prédéterminée de façon à programmer ledit dispositif logique programmable, ledit procédé comprenant les étapes consistant : à sélectionner une première durée plus courte que ladite durée prédéterminée ; et à appliquer (104) un premier nombre d'impulsions de programmation à haute tension sur chacune desdites cellules EPROM (10), chacune desdites impulsions de programmation à haute tention présentant une première amplitude et ayant ladite première durée, ledit nombre étant au moins égale à un ; caractérisé en ce que le procédé inclut en outre les étapes consistant ; à sélectionner une deuxième durée plus courte que ladite première durée ; et à appliquer (204) un deuxième nombre d'impulsions de programmation à haute tension sur chacune desdites cellules EPROM (10), chacune desdites impulsions de programmation à haute tension présentant une deuxième amplitude au moins aussi élevée que ladite première amplitude et ayant ladite deuxième durée, ledit deuxième nombre étant au moins égal à un.

2. Procédé de programmation selon la revendication 1, caractérisé en outre en ce que : après que chaque impulsion dudit premier nombre d'impulsions de programmation à haute tension de ladite première amplitude et de ladite première durée ait été appliquée sur l'une desdites cellules EPROM (10), la mesure (105) de la tension de seuil de ladite cellule desdites cellules EPROM (10) est réalisée ; et si ladite tension de seuil telle que mesurée est au moins égale à une première tension prédéterminée, l'arrêt (315) de la programmation de ladite cellule desdites cellules EPROM (10) est décidé.

3. Procédé de programmation selon la revendication 2, caractérisé par : le comptage (103, 108) dans une première étape de comptage du premier nombre desdites impulsions de programmation à haute tension de ladite première amplitude et de ladite première durée appliquées sur ladite cellule desdites cellules EPROM (10) ; et, si ladite tension de seuil telle que mesurée est au moins égale à une première tension prédéterminée, alors avant d'arrêter, (315) la programmation de ladite cellule desdites cellules EPROM (10), par une nouvelle application (106) à ladite cellule desdites cellules EPROM du premier nombre d'impulsions de programmation à haute tension comptées dans ladite première étape de comptage.

4. Procédé de programmation selon la revendication 3, caractérisé en ce qu'il existe un premier nombre maximum prédéterminé desdites impulsions de programmation à haute tension de ladite première durée pouvant être appliquées sur chacune desdites cellules EPROM.

5. Procédé de programmation selon la revendication 4, caractérisé en ce que, si (107), après que ledit premier nombre maximum prédéterminé d'impulsions de programmation à haute tension de ladite première amplitude et de ladite première durée aient été appliquées, ladite tension de seuil telle que mesurée est inférieure à ladite première tension prédéterminée, le procédé inclut les étapes supplémentaires consistant: à appliquer de nouveau (111) sur ladite cellule desdites cellules EPROM (10) ledit premier nombre maximum prédéterminé d'impulsions de programmation à haute tension de ladite première amplitude et de ladite première durée, à mesurer de nouveau (113) ladite tension de seuil de ladite cellule desdites EPROM (10) et, si ladite tension de seuil telle que mesurée est au moins égale à ladite première tension prédéterminée, à arrêter (315) la programmation de ladite première desdites cellules EPROM (10).

6. Procédé de programmation selon l'une quelconque des revendications précédentes, caractérisé en outre en ce que: après que chaque impulsion dudit deuxième nombre d'impulsions de programmation à haute tension de ladite deuxième amplitude et de ladite deuxième durée ait été appliquée sur la cellule desdites cellules EPROM (10), la mesure (205) de la tension de seuil sur ladite cellule desdites cellules EPROM (10) est réalisée ; et si ladite tension de seuil telle que mesurée est au moins égale à une deuxième tension prédéterminée, l'arrêt (315) de la programmation de ladite première desdites cellules EPROM (10) est décidé.

7. Procédé de programmation selon la revendication 6, caractérisé en ce que ladite deuxième tension prédéterminée est au moins égale à ladite première tension prédéterminée.

8. Procédé de programmation selon la revendication 7, dans lequel ladite deuxième tension prédéterminée est supérieure à ladite première tension prédéterminée.

9. Procédé de programmation selon l'une des revendications 6 à 8, caractérisé en outre en ce que : le comptage (203, 208) dans une deuxième étape de comptage du deuxième nombre d'impulsions de programmation à haute tension de ladite deuxième amplitude et de ladite deuxième durée qui sont appliquées sur l'une desdites cellules EPROM est réalisé ; et si ladite tension de seuil telle que mesurée est au moins égale à une deuxième tension prédéterminée, alors avant d'arrêter (315) la programmation de ladite cellule desdites cellules EPROM (10), l'application de nouveau (206) sur ladite cellule desdites cellules EPROM (10) du deuxième nombre d'impulsions de programmation à haute tension de ladite deuxième amplitude et de ladite deuxième durée comptées dans ladite deuxième étape de comptage est réalisée.

10. Procédé de programmation selon la revendication 9, caractérisé en ce qu'il existe un deuxième nombre maximum prédéterminé d'impulsions de programmation à haute tension de ladite deuxième amplitude et de ladite deuxième durée pouvant être appliquées sur ladite cellule desdites cellules de mémoire morte programmable effaçable.

11. Procédé de programmation selon la revendication 10, caractérisé en outre en ce que si (207), après que ledit deuxième nombre maximum prédéterminé d'impulsions de programmation à haute tension de ladite deuxième amplitude et de ladite deuxième durée aient été appliquées, ladite tension de seuil telle que mesurée est inférieure à ladite deuxième tension prédéterminée, le procédé inclut les étapes supplémentaires consistant à appliquer de nouveau (211) sur ladite cellule desdites cellules EPROM (10) ledit deuxième nombre maximum prédéterminé d'impulsions de programmation à haute tension de ladite deuxième amplitude et de ladite deuxième durée, à mesurer de nouveau ladite tension de seuil de ladite cellule desdites cellules EPROM (10), et, si ladite tension de seuil telle que mesurée est au moins égale à ladite deuxième tension prédéterminée, à arrêter (315) la programmation de ladite cellule desdites cellules EPROM (10).

12. Procédé de programmation selon les revendications 10 et 11, caractérisé en ce que ledit deuxième nombre maximum prédéterminée est au moins égal audit premier nombre maximum prédéterminé.

13. Procédé de programmation selon l'une quelconque des revendications précédentes, caractérisé en outre par : la sélection d'une troisième durée au moins importante que ladite deuxième durée ; et par l'application (304) d'un troisième nombre d'impulsions de programmation à haute tension à chacune desdites cellules EPROM (10), chacune desdites impulsions de programmation à haute tension présentant une troisième amplitude et ladite troisième durée, ledit troisième nombre étant au moins égal à un.

14. Procédé de programmation selon la revendication 13, caractérisé en outre en ce que : après chaque impulsion dudit troisième nombre d'impulsions de programmation à haute tension de ladite troisième amplitude et de ladite troisième durée sur l'une desdites cellules EPROM (10), la mesure (305) de la tension de seuil de ladite cellule desdites cellules EPROM (10) est réalisée ; et si ladite tension de seuil telle que mesurée est au moins égale à une troisième tension prédéterminée, l'arrêt (315) de la programmation de ladite cellule desdites cellules EPROM (10) est décidé.

15. Procédé de programmation selon la revendication 14, caractérisé en ce que ladite troisième tension prédéterminée est au moins égale à ladite deuxième tension prédéterminée.

16. Procédé de programmation selon la revendication 15, caractérisé en ce que ladite troisième tension prédéterminée est supérieure à ladite deuxième tension prédéterminée.

17. Procédé de programmation selon l'une quelconque des revendications 14 à 16, caractérisé en outre par le comptage (303, 308) dans une troisième étape de comptage du troisième nombre d'impulsions de programmation à haute tension de ladite troisième amplitude et de ladite troisième durée appliqué sur l'une desdites cellules EPROM; et si ladite tension de seuil telle que mesurée est au moins égale à une troisième tension prédéterminée, alors, avant l'arrêt (315) de la programmation de ladite cellule desdites cellules EPROM (10), par l'application (306) sur ladite cellule desdites cellules EPROM (10) du troisième nombre d'impulsions de programmation à haute tension de ladite troisième amplitude et de ladite troisième durée comptées dans ladite troisième étape de comptage.

18. Procédé de programmation selon la revendication 17, caractérisé en ce qu'il existe un troisième nombre maximum prédéterminé d'impulsions de programmation à haute tension de ladite troisème amplitude et de ladite troisième durée pouvant être appliquées sur ladite cellule desdites cellules EPROM (10).

19. Procédé de programmation selon la revendication 18, caractérisé en outre en ce que, si (307) après que ledit troisième nombre maximum prédéterminé d'impulsions de programmation à haute tension de ladite troisième amplitude et de ladite troisième durée aient été appliquées, ladite tension de seuil telle que mesurée est inférieure à ladite troisième tension prédéterminée, le procédé inclut en outre les étapes consistant : à appliquer de nouveau (311) sur ladite première desdites cellules EPROM (10) ledit troisième nombre maximum prédéterminé d'impulsions de programmation à haute tension de ladite troisième amplitude et de ladite troisième durée, à mesurer de nouveau ladite tension de seuil de ladite cellule desdites cellules EPROM (10), et, si ladite tension de seuil telle que mesurée est au moins égale à ladite troisième tension prédéterminée, à arrêter (315) la programmation de ladite cellule desdites cellules EPROM (10).

20. Procédé de programmation selon les revendications 18 ou 19, caractérisé en ce que ledit troisième nombre maximum prédéterminé est au moins égal audit deuxième nombre maximum prédéterminé.

21. Procédé de programmation selon la revendication 20, caractérisé en ce que ledit troisième nombre maximum prédéterminé est supérieur audit deuxième nombre maximum prédéterminé.

22. Procédé de programmation selon l'une quelconque des revendications 13 à 21, caractérisé en ce que ladite troisième amplitude est au moins égale à ladite deuxième amplitude.

23. Procédé de programmation selon la revendication 22, caractérisé en ce que ladite troisième amplitude est supérieure à ladite deuxième amplitude.

24. Procédé de programmation selon l'une quelconque des revendications 13 à 23, caractérisé en ce que ladite troisième durée est inférieure à ladite deuxième durée.

25. Procédé de programmation selon l'une quelconque des revendications 12 à 24, caractérisé en ce que ledit deuxième nombre maximum prédéterminé est supérieur audit premier nombre maximum prédéterminé.

26. Procédé de programmation selon l'une quelconque des revendications précédentes, caractérisé en ce que ladite deuxième amplitude est supérieure à ladite première amplitude.
